(19) Europäisches Patentamt

European Patent Office

Office européen des brevets

(11) **EP 1 829 222 B1**

(12) **EUROPEAN PATENT SPECIFICATION**

(45) Date of publication and mention
of the grant of the patent:
**24.12.2014 Bulletin 2014/52**

(51) Int Cl.:
*H03M 13/05* *(2006.01)*    *H03M 13/11* *(2006.01)*

(21) Application number: **05778539.6**

(22) Date of filing: **18.07.2005**

(86) International application number:
**PCT/US2005/025277**

(87) International publication number:
**WO 2006/065286 (22.06.2006 Gazette 2006/25)**

(54) **STRUCTURED LDPC DESIGN WITH VECTOR ROW GROUPING**

STRUKTURIERTER LDPC-ENTWURF MIT VEKTORZEILENGRUPPIERUNG

CODE DE PARITÉ LDPC STRUCTURÉ AVEC GROUPAGE DES LIGNES VECTEURS

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **15.12.2004 US 636700 P
19.04.2005 US 108949**

(43) Date of publication of application:
**05.09.2007 Bulletin 2007/36**

(60) Divisional application:
**11164129.6
11164133.8 / 2 365 636
11164139.5
11164141.1 / 2 365 637
11164143.7 / 2 365 638
11164148.6
11164153.6
11164158.5
11164164.3
11164172.6
11164174.2
11164177.5**

(73) Proprietor: **Motorola Mobility LLC
Libertyville, IL 60048 (US)**

(72) Inventors:
• **BLANKENSHIP, Yufei, W.
Streamwood, IL 60107 (US)**
• **BLANKENSHIP, T., Keith
Streamwood, IL 60107 (US)**
• **CLASSON, Brian, K.
Palatine, IL 60067 (US)**

(74) Representative: **Openshaw, Paul Malcolm
Openshaw & Co.
8 Castle Street
Farnham
Surrey GU9 7HR (GB)**

(56) References cited:
**WO-A1-2004/102810     US-B2- 6 718 508**

• **ROBERT XU, LIUQING YUAN, YOUGANG ZHANG,
LI ZENG: "High Girth LDPC coding for OFDMA
PHY"[Online] 3 November 2004 (2004-11-03),
XP002509792 Retrieved from the Internet: URL:
http://www.ieee802.org/16/tge/contrib/ C80216e-
04_423.pdf> [retrieved on 2009-01-13]**
• **B. CLASSON ET AL.: "LDPC coding for OFDMA
PHY"[Online] 10 January 2005 (2005-01-10),
pages 0-9, XP002509951 Retrieved from the
Internet: URL:http://www.ieee802.org/16/tge/
contrib/ C80216e-05_006.pdf> [retrieved on
2009-01-12]**

**Description**

The present invention relates generally to encoding and decoding data and in particular, to a method and apparatus for encoding and decoding data utilizing low-density parity-check (LDPC) codes.

Background of the Invention

As described in United States Patent Application Serial No. 10/839995, which is incorporated by reference herein, a low-density parity-check (LDPC) code is a linear block code specified by a parity-check matrix **H.** In general, an LDPC code is defined over a Galois Field $GF(q), q{\geq}2.$ If $q{=}2$, the code is a binary code. All linear block codes can be described as the product of a $k$-bit information vector $\mathbf{s}_{1\times k}$ with a code generator matrix $\mathbf{G}_{k\times n}$ to produce an $n$-bit codeword $\mathbf{x}_{1\times n}$, where the code rate is $r{=}k/n$. The codeword $\mathbf{x}$ is transmitted through a noisy channel, and the received signal vector y is passed to the decoder to estimate the information vector $\mathbf{s}_{1\times k}$.

Given an $n$-dimensional space, the rows of **G** span the $k$-dimensional codeword subspace $C$, and the rows of the parity-check matrix $\mathbf{H}_{m\times n}$ span the $m$-dimensional dual space $C^{\perp}$, where $m{=}n{-}k$. Since $\mathbf{x}{=}\mathbf{sG}$ and $\mathbf{GH^T}{=}\mathbf{0,}$ it follows that $\mathbf{xH^T}{=}\mathbf{0}$ for all codewords in subspace C, where "T" (or *"T"*) denotes matrix transpose. In the discussion of LDPC codes, this is generally written as

$$\mathbf{H}\mathbf{x}^{\mathbf{T}} = \mathbf{0}^{\mathbf{T}}, \tag{1}$$

where 0 is a row vector of all zeros, and the codeword $\mathbf{x}{=}[\mathbf{s}\ \mathbf{p}]{=}[s_0,\ s_1,\ ...,s_{k-1},\ p_0,\ p_1,\ ...,\ p_{m-1}]$, where $p_0,\ ...,\ p_{m-1}$ are the parity-check bits; and $s_0,\ ...,\ s_{k-1}$ are the systematic bits, equal to the information bits within the information vector.

For an LDPC code the density of non-zero entries in **H** is low, i.e., there are only a small percentage of 1's in **H,** allowing better error-correcting performance and simpler decoding than using a dense **H.** A parity-check matrix can be also described by a bipartite graph. The bipartite graph is not only a graphic description of the code but also a model for the decoder. In the bipartite graph, a codeword bit (therefore each column of **H)** is represented by a variable node on the left, and each parity-check equation (therefore each row of **H)** is represented by a check node on the right. Each variable node corresponds to a column of **H** and each check node corresponds to a row of **H,** with "variable node" and "column" of **H** referred to interchangeably, as are "check node" and "row" of **H.** The variable nodes are only connected to check nodes, and the check nodes are only connected to variable nodes. For a code with $n$ codeword bits and $m$ parity bits, variable node $v_i$ is connected to check node $c_j$ by an edge if codeword bit $i$ participates in check equation $j$, $i = 0, 1, ..., n$-1, $j = 0, 1, ..., m$-1. In other words, variable node $i$ is connected to check node $j$ if entry $h_{ji}$ of the parity-check matrix **H** is 1. Mirroring Equation (1), the variable nodes represent a valid codeword if all check nodes have even parity.

An example is shown below to illustrate the relationship between the parity-check matrix, the parity-check equations, and the bipartite graph. Let an $n$ = 12, rate-1/2 code be defined by

$$\mathbf{H} = \left[\begin{array}{cccccc|cccccc} 1 & 0 & 1 & 0 & 0 & 0 & 1 & 1 & 0 & 0 & 0 & 0 \\ 0 & 1 & 0 & 0 & 1 & 0 & 0 & 1 & 1 & 0 & 0 & 0 \\ 0 & 0 & 1 & 0 & 0 & 1 & 1 & 0 & 1 & 1 & 0 & 0 \\ 1 & 0 & 0 & 1 & 0 & 0 & 0 & 0 & 0 & 1 & 1 & 0 \\ 0 & 1 & 0 & 0 & 1 & 0 & 0 & 0 & 0 & 0 & 1 & 1 \\ 0 & 0 & 0 & 1 & 0 & 1 & 1 & 0 & 0 & 0 & 0 & 1 \end{array}\right]\Big\}m \tag{2}$$

$$\underbrace{\phantom{xxxxxxxxxxxxxxxxxxxxxxxx}}_{n},$$

with the left side portion corresponding to $k$ (=6) information bits s, the right side portion corresponding to $m$ (=6) parity bits **p.** Applying (1), the **H** in (2) defines 6 parity-check equations as follows:

$$\begin{cases} x_0 + x_2 + x_6 + x_7 = 0 \\ x_1 + x_4 + x_7 + x_8 = 0 \\ x_2 + x_5 + x_6 + x_8 + x_9 = 0 \\ x_0 + x_3 + x_9 + x_{10} = 0 \\ x_1 + x_4 + x_{10} + x_{11} = 0 \\ x_3 + x_5 + x_6 + x_{11} = 0 \end{cases} \qquad (3)$$

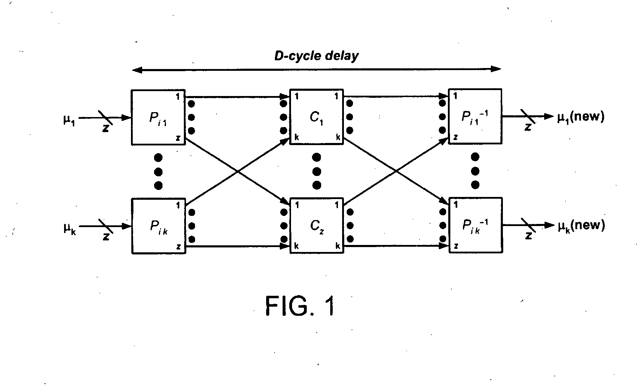

H also has the corresponding bipartite graph shown in FIG. 1.

The general LDPC code described above may not be easy to implement in practice. Structures are often introduced into the parity-check matrix to allow fast encoding and decoding without sacrificing the error-correcting performance. A structured LDPC code design starts with a small $m_b \times n_b$ binary base matrix $\mathbf{H}_b$, makes $z$ copies of $\mathbf{H}_b$, and interconnects the z copies to form a large *mxn* H matrix, where $m= m_b \times z$, $n= n_b \times z$. Using the matrix representation, to build an **H** from $\mathbf{H}_b$ each 1 in $\mathbf{H}_b$ is replaced by a zxz permutation submatrix, and each 0 in $\mathbf{H}_b$ is replaced by a zxz all-zero submatrix. The representation of the expansion of $\mathbf{H}_b$ is called the model matrix and is denoted by $\mathbf{H}_{bm}$. Thus $\mathbf{H}_{bm}$ is simply a shorthand notation for **H** when z is known. This procedure essentially maps each edge of $\mathbf{H}_b$ to a vector edge of length $z$ in **H,** each variable node of $\mathbf{H}_b$ to a vector variable node of length z in **H,** and each check node of $\mathbf{H}_b$ to a vector check node of length z in **H.** For a structured LDPC, the zxz submatrix may be a permutation matrix, a sum of permutation matrices, or any type of binary matrix. Since a permutation matrix **P** has a single 1 in each row and a single 1 in each column, the weight distribution of the expanded matrix **H** is the same as the base matrix $\mathbf{H}_b$ if the permutation submatrix is used. Therefore, the weight distribution of $\mathbf{H}_b$ is chosen as close to the desired final weight distribution as possible. The permutation submatrices comprising **H** can be very simple without compromising performance, such as simple cyclic shifts and/or bit-reversals. In the case of cyclic shifts, $\mathbf{H}_{bm}$ can be written by replacing the 1's in $\mathbf{H}_b$ by non-negative integers that represent the shift size and the 0's in $\mathbf{H}_b$ are replaced by 1.In the transmitter, a vector **u** of $k$ information bits is encoded based on **H** (or equivalently $\mathbf{H}_{bm}$) to produce a vector **x** of $n$ code bits, where $k=n-m=z \times k_b$, $k_b = (n_b-m_b)$. Vector **x** is sent through a noisy channel and a vector **y** of $n$ contaminated signals are received. At the receiver, the LDPC decoder attempts to estimate x based on received vector **y** and the parity-check matrix **H.** The receiver obtains a contaminated version **y** of the transmitted codeword **x.** To decode **y** and estimate the original information sequence s, an iterative decoding algorithm, such as belief propagation, is usually applied based on the bipartite graph. Soft information in the format of log-likelihood ratios (LLR) of the codeword bits is passed between the bank of variable nodes and the bank of check nodes. The iteration is stopped either when all check equations are satisfied or a maximum allowed iteration limit is reached.

Structured LDPC codes may also be decoded with a layered decoder. A layered decoder typically has hardware to processes an entire row at one time. The layered decoder can potentially reduce the number of iterations required to achieve a given level of performance, and potentially increase throughput if not enough hardware exists to process all block rows at one time. Layer grouping can also be used where the base matrix $\mathbf{H}_b$ is constrained such that groups of base rows do not intersect, which means that the base rows within a group have at most a single 1 within a base column (or equivalently, within each group the rows of $\mathbf{H}_{bm}$ have at most a single non-negative entry within a column). Layer grouping can be used to further increase LDPC decoder speed since fewer iterations are needed to achieve a certain error-correcting performance.

In addition, the base matrix and assignment of permutation matrices for a given target parity check matrix **H** can be designed to provide an LDPC code that has good error-correcting performance and can be efficiently encoded and decoded. In United States Patent Application Serial No. 10/839,995, a structured parity-check matrix **H** is described, wherein **H** is an expansion of a base matrix $\mathbf{H}_b$ and wherein $\mathbf{H}_b$ comprises a section $\mathbf{H}_{b1}$ and a section $\mathbf{H}_{b2}$, and wherein $\mathbf{H}_{b2}$ comprises a first part comprising a column $\mathbf{h}_b$ having an odd weight greater than 2, and a second part comprising matrix elements for row *i,* column j equal to 1 for *i=j,* 1 for *i=j*+1, and 0 elsewhere. The expansion of the base matrix $\mathbf{H}_b$ uses identical submatrices for 1s in each column of the second part $\mathbf{H'}_{b2}$, and the expansion uses paired submatrices for an even number of 1s in $\mathbf{h}_b$.

Although layered decoding with layer grouping can be used to potentially reduce the amount of processing and potentially increase throughput, a technique does not exist for designing the base matrix and assigning the permutation matrices for a given target **H** size which allows efficient encoding and layered decoding with layer grouping. Therefore, a need exists for building features into structured LDPC codes which can be encoded efficiently and high-speed layered decoded.

The document ROBERT XU, LIUQING YUAN, YOUGANG ZHANG, LI ZENG: "High Girth LDPC coding for OFDMA PHY"[Online] 3 November 2004 (2004-11-03), XP002509792 Retrieved from the Internet: URL:http://www.ieee802.org/16/tge/contrib/C80216e-04_423.pdf, discloses high girth LPDC coding for OFDMA PHY. Each LDPC code in a set of LDPC codes is defined by a matrix **H** of size $m$-by-$n$, where $n$ is the length of the code and $m$ is the number of parity check bits in the code. The number of systematic bits is $k=n-m$.

The matrix **H** is defined as

$$\mathbf{H} = \begin{bmatrix} \mathbf{P}_{0,0} & \mathbf{P}_{0,1} & \mathbf{P}_{0,2} & \cdots & \mathbf{P}_{0,n_b-2} & \mathbf{P}_{0,n_b-1} \\ \mathbf{P}_{1,0} & \mathbf{P}_{1,1} & \mathbf{P}_{1,2} & \cdots & \mathbf{P}_{1,n_b-2} & \mathbf{P}_{1,n_b-1} \\ \mathbf{P}_{2,0} & \mathbf{P}_{2,1} & \mathbf{P}_{2,2} & \cdots & \mathbf{P}_{2,n_b-2} & \mathbf{P}_{2,n_b-1} \\ \vdots & \vdots & \vdots & \cdots & \vdots & \vdots \\ \mathbf{P}_{m_b-1,0} & \mathbf{P}_{m_b-1,1} & \mathbf{P}_{m_b-1,2} & \cdots & \mathbf{P}_{m_b-1,n_b-2} & \mathbf{P}_{m_b-1,n_b-1} \end{bmatrix} = \mathbf{P}^{H_b}$$

where $\mathbf{P}_{i,j}$ is one of a set of $z$-by-$z$ permutation matrices or a $z$-by-$z$ zero matrix. The matrix H is expanded from a binary base matrix $\mathbf{H}_b$ of size $m_b$-by-$n_b$, where $n = z \cdot n_b$ and $m = z \cdot m_b$, and z is an integer $\geq 1$. The base matrix is expanded by replacing each 1 in the base matrix with a $z$-by-$z$ permutation matrix, and each 0 with a $z$-by-$z$ zero matrix. The base matrix $n_b$ is an integer multiple of 24.

The permutations used are circular right shifts, and the set of permutation matrices contains the zxz identity matrix and circular right hsifted versions of the identity matrix. Because each permutation matrix is specified by a single circular right shift, the binary base matrix information and permutation replacement information can be combined into a single compact model matrix $\mathbf{H}_{bm}$. The model matrix $\mathbf{H}_{bm}$ is the same size as the binary base matrix $\mathbf{H}_b$, with each binary entry at ($i,j$) of the base matrix $\mathbf{H}_b$ replaced to create the model matrix $\mathbf{H}_{bm}$. Each 0 in $\mathbf{H}_b$ is replaced by a negative value (e.g., by "C1) to denote a $z \times z$ all-zero matrix, and each 1 in $\mathbf{H}_b$ is replaced by a circular shift size $p(i,j) \geq 0$. The model matrix $\mathbf{H}_{bm}$ can then be directly expanded to **H**. $\mathbf{H}_b$ is partitioned into two sections, where $\mathbf{H}_{b1}$ corresponds to the systematic bits and $\mathbf{H}_{b2}$ corresponds to the parity-check bits, such that $\mathbf{H}_b = ⌊(\mathbf{H}_{b1})_{m_b \times k_b} \mid (\mathbf{H}_{b2})_{m_b \times m_b}⌋$. Section $\mathbf{H}_{b2}$ is further partitioned into two sections, where vector $\mathbf{h}_b$ has odd weight, and $\mathbf{H}'_{b2}$ has a dual-diagonal structure with matrix elements at row $i$, column j equal to 1 for $i=j$, 1 for $i=j+1$, and 0 elsewhere:

$$\mathbf{H}_{b2} = \begin{bmatrix} \mathbf{h}_b & \vdots & \mathbf{H}'_{b2} \end{bmatrix}$$
$$= \begin{bmatrix} h_b(0) & \vdots & 1 & & & & \\ h_b(1) & \vdots & 1 & 1 & & \mathbf{0} & \\ \cdot & \vdots & & 1 & \ddots & & \\ \cdot & \vdots & & & \ddots & 1 & \\ \cdot & \vdots & & \mathbf{0} & & 1 & 1 \\ h_b(m_b-1) & \vdots & & & & & 1 \end{bmatrix}$$

The base matrix has $h_b(0)=1$, $h_b(m_b-1)=1$, and a third value $h_b(j)$, $0<j<(m_b-1)$ equal to 1. The base matrix structure avoids having multiple weight-1 columns in the expanded matrix. In particular, the non-zero submatrices are circularly right shifted by a particular circular shift value. Each 1 in $\mathbf{H}'_{b2}$ is assigned a shift size of 0, and is replaced by a zxz identity matrix when expanding to **H**. The two 1s located at the top and the bottom of $\mathbf{h}_b$ are assigned equal shift sizes, and the third 1 in the middle of $\mathbf{h}_b$ is given an unpaired shift size.

Brief Description of the Drawings

FIG. 1 shows a parity-check processing flow.
FIG. 2 through FIG. 4 shows FER performance for rate ½, 2/3, and ¾.

Detailed Description of the Drawings

For efficient encoding and good error-correcting performance in a structured LDPC design, the parity portion $\mathbf{H}_{b2}$ comprises groups of size $q$ within $\mathbf{H}_{b2}$, and the same grouping of $\mathbf{H}_{b2}$ are extended to the information portion $\mathbf{H}_{b1}$. Specifically, the parity-check matrix $\mathbf{H}$ is constructed as follows.

(1) The parity portion $\mathbf{H}_{b2}$ has the format

$$\mathbf{H}_{b2} = \begin{bmatrix} \mathbf{h}_b & \vdots & \mathbf{H}'_{b2} \end{bmatrix}$$

$$= \begin{bmatrix} h_b(0) & \vdots & 1 & & & & \\ h_b(1) & \vdots & 1 & 1 & & \mathbf{0} & \\ . & \vdots & & 1 & \ddots & & \\ . & \vdots & & & \ddots & 1 & \\ . & \vdots & \mathbf{0} & & 1 & 1 \\ h_b(m_b-1) & \vdots & & & & 1 \end{bmatrix}.$$

The column $h_b$ has weight $w_h >= 3$, and the 1's of $h_b$ are arranged such that $m_b/q$ groups can be formed, where the q rows of $\mathbf{H}_{b2}$ within each group do not intersect. Two or more base rows (of $\mathbf{H}_b$ or $\mathbf{H}_{b2}$) are said to not intersect if the group of rows have at most one 1 entry within each base column. In other words, two rows do not intersect if the dot product of the two rows is zero.

In one example, group $j$ contains rows with index $g(j)=\{j, j+m_b/q, j+2 \times m_b/q, ...,j+(q-1) \times m_b/q\}$, $j = 0, 1, ..., (m_b/q-1)$, $m_b/q > 1$. In this case, if $w_h = 3$, one example of column $h_b$ contains three non-zero entries $h_b(0) = 1$, $h_b(m_b-1) = 1$, and $h_b(a) = 1$, where $a \notin g(0)$, $a \notin g(m_b/q-1)$. For example, when q=2 and $m_b$=24, the pairs of base rows j and j+12 have at most one non-zero entry, for j=0 to 11. For $m_b$=12 and q=2, the $h_b$ column preferably has weight 3, with $h_b(0)$=1 and $h_b(mb-1)$=1 and $hb(a)$=1.

Note that by definition the first and second base row cannot be in the same group because the rows intersect. The Two adjacent rows intersect because the second part of $\mathbf{H}_{b2}$ comprises matrix elements for row $i$, column $j$ equal to 1 for $i=j$, 1 for $i=j+1$, and 0 elsewhere. However, in the decoder the order of processing rows can be changed without affecting performance. Therefore, base row or base column permutations and rearrangements of the $\mathbf{H}_b$ may be performed while still maintaining desirable decoding properties. It is straightforward to show that rows and columns may be rearranged such that all rows within a group are adjacent, while still maintaining the non-intersection properties of the construction above.

(2) The information portion $\mathbf{H}_{b1}$ is constructed such that all $q$ rows within group $g(j)$ intersect in $<=l$ positions, where $l$ is equal to the number of columns in $\mathbf{H}_b$ that have column weight greater than $m_b/q$. If the column weights are less than or equal to $m_b/q$ conditions (2) can be covered in condition (1) by stating that the rows of $\mathbf{H}_b$ within a group do not intersect.

In some systems, different base matrices may be needed. For example, multiple base matrices may be used for a given code rate, or one base matrix may be used for each code rate. The non-intersecting construction described may be used for a subset of all base matrices. For example, if three base matrices with the same number of columns are needed for R = ½, 2/3, and ¾, then the non-intersecting construction may be used for R = ½ and 2/3, but not used for R = ¾ to maintain good performance. Alternatively, the non-intersecting construction may be used for R=1/2 and not for R=2/3 and R=3/4.

As an example of performance considerations, consider base matrices for code rates 1/2, 2/3, and 3/4 that have 24 columns and 12, 8, and 6 rows, respectively. The performance of the resulting code may suffer, especially when the size of the base matrix is relatively small (e.g., R=2/3 and 3/4, 24 columns). This is because good performance requires a good column weight distribution (particularly for the columns associated with the information positions). For example, weight-4 columns may be required for good performance in a R=3/4 code, but a 6x24 base $\mathbf{H}$ matrix may only have up to weight 3 under the constraint that pairs of base matrix rows have no overlapping entries.

Implementation Architecture

The processing of groups of bits in a structured code is examined in further detail. For a structured LDPC code with expansion factor z, the z parity checks within a vector check node (corresponding to a row of the base matrix) can be computed in parallel. This is because the code structure (which contains permutations) guarantees that the message from any given variable node within a vector variable node (corresponding to a column of the base matrix) is needed by at most one of the z parity check node within a vector check node. An exemplary block diagram of the parity check processing flow is provided in Figure 1. The grouped messages $\mu_j$ from vector variable nodes to vector check node $i$, $1 \leq j \leq d_r(i)$, corresponding to the $d_r(i)$ non-zero entries of the $i$-th row of the base matrix are cyclically permuted according to the permutation submatrix $P_{ij}$, $1 \leq j \leq d_r(i)$, and presented to the z parallel parity check circuits $C_l$ within vector check node $i$, $1 \leq l \leq z$. The parity check circuitry produces messages which are inverse permuted to obtain the updated messages $\mu_j$(new), which can be utilized in consequent decoding steps. Note that $d_r(i)$ is denoted k in the figure.

The digital logic in the processing blocks of Figure 1 can be entirely pipelined, that is, the intermediate results stored by any register are not needed to generate results for any previous register in the circuit. As described in the figure, once messages are passed into the circuit, updated messages are generated $D$ cycles later.

Given this model, consider a base matrix where for any two rows, say $r$ and $s$, the sets of columns with non-trivial (zero) entries do not intersect. Thus, the vector parity check nodes corresponding to these two rows use (and update) entirely different sets of messages, which are related to two different sets of vector variable nodes. In this case, since the circuitry of Figure 1 is pipelined, the vector parity checks for both of row $r$ and row $s$ can be computed in $D+1$ cycles. This is done by feeding the messages for row $s$ one cycle later than for row $r$ into a processing unit depicted in Figure 1. If the messages for row $r$ were fed in at time $t$, they will be updated at time $t+D$, followed by the update of row $s$ messages at time $t+D+1$. This can be represented with Figure 1 and another copy of Figure 1 below the first copy offset by a cycle.

In a fully pipelined approach, the base matrix is designed so that the rows of $H_b$ can be divided into $m_b/2$ groups, where for the two rows within a group, the sets of columns with non-trivial entries do not intersect. Note that the grouped rows do not have to be consecutive because the decoder could be controlled to process the parity check matrix rows out of order. Alternatively, the vector rows of the parity-check matrix $H$ can be permuted such that every two consecutive vector rows do not intersect since row permutation has no effect on decoding performance. In the fully pipelined approach the throughput can be nearly doubled relative to the case where there are no paired rows (which requires $2D$ clock cycles to process 2 rows). This is because processing of any subsequent row must be delayed until all messages on the current row being processed have been updated. Therefore the fully pipelined decoding allows significant throughput increase without extra hardware cost. It can be also viewed that the fully pipelined design achieves almost the same throughput as a design that uses twice as much hardware where two vector rows within a group are decoded simultaneously on two processing units. Processing two rows that are non-intersecting can be viewed as Figure 1 with another Figure 1 to the right, with a total delay of 2D.

In the discussion above, group size of 2 is assumed. In general, the base matrix may be designed such that the $m_b$ rows of $H_b$ can be divided into $m_b/q$ groups, where the $q$ vector rows within each group do not intersect (called "$q$-grouping" in the following). When fully pipelined, $q$ vector rows can be started in the pipeline consecutively, with one cycle separation between consecutive vector rows. Thus the $q$ rows can be finished in $D+q-1$ cycles. Thus the throughput of $q$-grouping design is nearly $q$ times as much as the design where no grouping exists *since q* vector rows takes $Dxq$ cycles to compute. The grouping size $q$ parity-check matrix has a maximum allowed column weight of $m_b/q$. Thus $q$ should be selected properly so that good error-correcting performance can be achieved with the maximum allowed column weight.

Although the design is discussed under the consideration of layered decoding, a parity-check matrix with q-grouping size q design can be decoded using any other decoding architecture. For example, the belief propagation decoding with flooding scheduling is still applicable, where all check nodes are processed simultaneously, and all variable nodes are processed simultaneously.

Code Description

Each of the LDPC codes is a systematic linear block code. Each LDPC code in the set of LDPC codes is defined by a matrix **H** of size $m$-by-$n$, where $n$ is the length of the code and $m$ is the number of parity check bits in the code. The number of systematic bits is $k=n-m$.

The matrix **H** is defined as an expansion of a base matrix and can be represented by

$$H = \begin{bmatrix} P_{0,0} & P_{0,1} & P_{0,2} & \cdots & P_{0,n_b-2} & P_{0,n_b-1} \\ P_{1,0} & P_{1,1} & P_{1,2} & \cdots & P_{1,n_b-2} & P_{1,n_b-1} \\ P_{2,0} & P_{2,1} & P_{2,2} & \cdots & P_{2,n_b-2} & P_{2,n_b-1} \\ \vdots & \vdots & \vdots & \cdots & \vdots & \vdots \\ P_{m_b-1,0} & P_{m_b-1,1} & P_{m_b-1,2} & \cdots & P_{m_b-1,n_b-2} & P_{m_b-1,n_b-1} \end{bmatrix} = P^{H_b}$$

where $P_{i,j}$ is one of a set of $z$-by-$z$ right-shifted identity matrices or a $z$-by-$z$ zero matrix. The matrix $H$ is expanded from a binary base matrix $H_b$ of size $m_b$-by-$n_b$, where $n = z \cdot n_b$ and $m = z \cdot m_b$, and z is a positive integer. The base matrix is expanded by replacing each 1 in the base matrix with a $z$-by-$z$ right-shifted identity matrix, and each 0 with a $z$-by-$z$ zero matrix. Therefore the design accommodates various packet sizes by varying the submatrix size z.

Because each permutation matrix is specified by a single circular right shift, the binary base matrix information and permutation replacement information can be combined into a single compact model matrix $H_{bm}$. The model matrix $H_{bm}$ is the same size as the binary base matrix $H_b$, with each binary entry at $(i,j)$ of the base matrix $H_b$ replaced to create the model matrix $H_{bm}$. Each 0 in $H_b$ is replaced by a negative value (e.g., by -1) to denote a zxz all-zero matrix, and each 1 in $H_b$ is replaced by a circular shift size $p(i,j) \geq 0$. The model matrix $H_{bm}$ can then be directly expanded to $H$.

The base matrix $H_b$ is partitioned into two sections, where $H_{b1}$ corresponds to the systematic bits and $H_{b2}$ corresponds to the parity-check bits, such that $H_b = \lfloor (H_{b1})_{m_b \times k_b} \mid (H_{b2})_{m_b \times m_b} \rfloor$. Section $H_{b2}$ is further partitioned into two sections, where vector $h_b$ has odd weight, and $H'_{b2}$ has a dual-diagonal structure with matrix elements at row $i$, column $j$ equal to 1 for $i=j$, 1 for $i=j+1$, and 0 elsewhere:

$$H_{b2} = \begin{bmatrix} h_b & \vdots & H'_{b2} \end{bmatrix}$$
$$= \begin{bmatrix} h_b(0) & \vdots & 1 & & & & \\ h_b(1) & \vdots & 1 & 1 & & 0 & \\ \cdot & \vdots & & 1 & \ddots & & \\ \cdot & \vdots & & & \ddots & 1 & \\ \cdot & \vdots & 0 & & & 1 & 1 \\ h_b(m_b-1) & \vdots & & & & & 1 \end{bmatrix}$$

The base matrix has $h_b(0)=1$, $h_b(m_b-1)=1$, and a third value $h_b(j)$, $0<j<(m_b-1)$ equal to 1. The base matrix structure avoids having multiple weight-1 columns in the expanded matrix.

In particular, the non-zero submatrices are circularly right shifted identity matrix with a particular circular shift value. Each 1 in $H'_{b2}$ is assigned a shift size of 0, and is replaced by a zxz identity matrix when expanding to $H$. The two 1s located at the top and the bottom of $h_b$ are assigned equal shift sizes, and the third 1 in the middle of $h_b$ is given an unpaired shift size. The unpaired shift size is equal to 0.

Examples

As an example, code design for 19 code sizes of 576 to 2304 is described. Each base model matrix is designed for a shift size $z_0=96$. A set of shift sizes $\{p(i,j)\}$ is defined for the base model matrix and used for other code sizes of the same rate. For other code sizes, the shift sizes are derived from the base model matrix as follows. For a code size corresponding to expansion factor $z_f$, its shift sizes $\{p(f, i, j)\}$ are derived from $\{p(i,j)\}$ by scaling $p(i,j)$ proportionally,

$$p(f,i,j) = \begin{cases} p(i,j), & p(i,j) \leq 0 \\ \left\lfloor \dfrac{p(i,j)z_f}{z_0} \right\rfloor = \left\lfloor \dfrac{p(i,j)}{\alpha_f} \right\rfloor, & p(i,j) > 0 \end{cases}$$

Note that $\alpha_f = z_0/z_f$ and $\lfloor x \rfloor$ denotes the flooring function which gives the nearest integer towards $-\infty$.

The model matrices are tabulated below for three code rates of ½, 2/3 and 3/4. The design for rate ½ have 6 groups with group size $q$ = 2. The design for rate 2/3 have 4 groups with group size $q$ = 2. The design for rate ¾ does not use the non-intersecting construction in order to achieve good performance.

**Rate 1/2:**

The base model matrix has size $n_b$=24, $m_b$=12 and an expansion factor $z_0$=96 (i.e., $n$=24*96=2304). To achieve other code sizes $n$, the expansion factor $z_f$ is equal to $n/24$.

```
-1 -1 34 -1 -1 59 -1 -1 68 -1 25 -1  7  0 -1 -1 -1 -1 -1 -1 -1 -1 -1 -1
-1 89 -1 -1 -1 -1 -1 62 -1 -1 49 82 -1  0  0 -1 -1 -1 -1 -1 -1 -1 -1 -1
58 -1 -1 20 -1 -1 -1 11 -1 81 -1 16 -1 -1  0  0 -1 -1 -1 -1 -1 -1 -1 -1
-1 -1 86 -1 -1 -1 53 -1 -1 69 49 -1 -1 -1 -1  0  0 -1 -1 -1 -1 -1 -1 -1
-1 -1 -1 -1 -1 -1 -1 16 10 -1 -1  6  0 -1 -1 -1  0  0 -1 -1 -1 -1 -1 -1
-1 -1 -1 -1 49 66 -1 92 -1 -1 61 47 -1 -1 -1 -1 -1  0  0 -1 -1 -1 -1 -1
-1 13 -1 -1 -1 -1 15 33 -1 71 -1 65 -1 -1 -1 -1 -1 -1  0  0 -1 -1 -1 -1
34 -1 -1 -1 -1 48 -1 -1 19 28 -1 -1 -1 -1 -1 -1 -1 -1 -1  0  0 -1 -1 -1
-1 -1 58 -1 75 -1 -1 -1 64 -1 68 -1 -1 -1 -1 -1 -1 -1 -1 -1  0  0 -1 -1
-1 -1 -1 16 -1 -1 -1 92 47 -1 -1 64 -1 -1 -1 -1 -1 -1 -1 -1 -1  0  0 -1
-1 29 -1 -1  9 -1 -1 -1 -1 28 59 -1 -1 -1 -1 -1 -1 -1 -1 -1 -1 -1  0  0
-1 -1 -1 38 -1 -1 83 -1 50 86 -1 -1  7 -1 -1 -1 -1 -1 -1 -1 -1 -1 -1  0
```

Rate 2/3:

The base model matrix has size $n_b$=24, $m_b$=8 and an expansion factor $z_0$=96 (i.e., $n$=24*96=2304). To achieve other code sizes $n$, the expansion factor $z_f$ is equal to n/24.

```
56 -1 -1 54 -1 75 -1 82 93 -1 -1 49 -1  3 83 -1  7  0 -1 -1 -1 -1 -1 -1
-1 47 36 -1 -1  4 62 -1 14 -1 -1 37 63 -1 -1 11 -1  0  0 -1 -1 -1 -1 -1
-1 61 -1 37 -1 -1 84 -1 54 -1  2 93 -1 23 -1 79  0 -1  0  0 -1 -1 -1 -1
84 -1 -1 77 -1 80 -1 31 78 -1  9 -1 65 -1 -1 58 -1 -1 -1  0  0 -1 -1 -1
-1 55 40 -1  8 -1 13 -1 -1 79 60 -1 95 -1 -1 30 -1 -1 -1 -1  0  0 -1 -1
11 -1 -1 45  0 -1 -1 10 -1 13 21 -1 -1 70 86 -1 -1 -1 -1 -1 -1  0  0 -1
35 -1  6 -1 16 40 -1 30 -1 57 -1 -1 89 -1 74 -1 -1 -1 -1 -1 -1 -1  0  0
-1 89 95 -1 77 -1 56 -1 -1 74 -1 14 -1 78 14 -1  7 -1 -1 -1 -1 -1 -1  0
```

Rate 3/4:

The base matrix has size $n_b$=24, $m_b$=6 and an expansion factor $z_0$=96 (i.e., $n$=24*96=2304). To achieve other code sizes $n$, the expansion factor $z_f$ is equal to $n/24$.

```
43 90 41 40 19 -1 -1 -1 -1 86 -1 83 26 74 50 -1 -1 62  7  0 -1 -1 -1 -1
-1 -1 95 61 84  2 16 -1 -1  0 -1 -1 -1 20 30 91 18 95 -1  0  0 -1 -1 -1
-1 -1 -1 87  0 -1 58 16 -1 87 16 -1 -1 93 -1 54 24 33  0 -1  0  0 -1 -1
-1 12 -1 -1 65 48 -1 10 10 95 -1 49 -1 52  6 -1 36 57 -1 -1 -1  0  0 -1
65 -1 31 -1 15 -1 12 -1  6 57  0 89  9 29 -1 -1 -1 75 -1 -1 -1 -1  0  0
-1 65 -1 -1 48 40 -1 83 18 45 29 -1 73 84 -1 77 -1 95  7 -1 -1 -1 -1  0
```

Performance

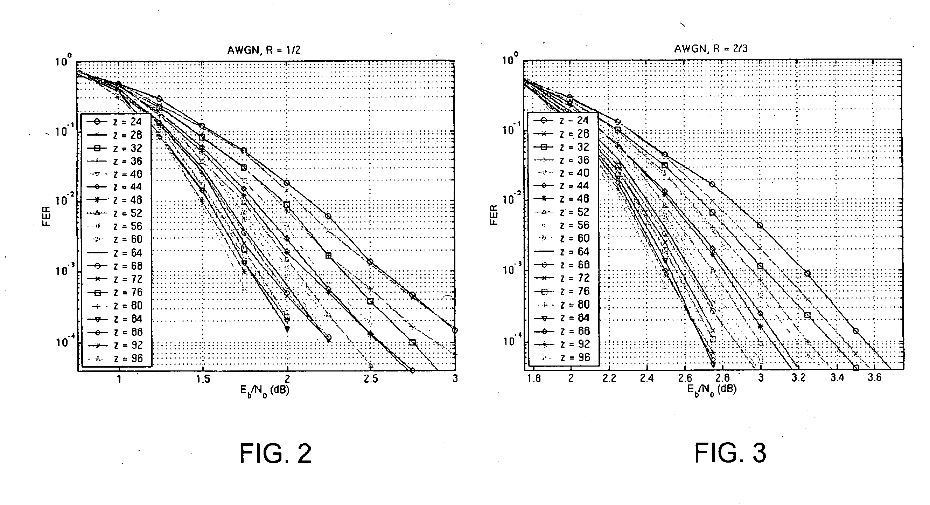

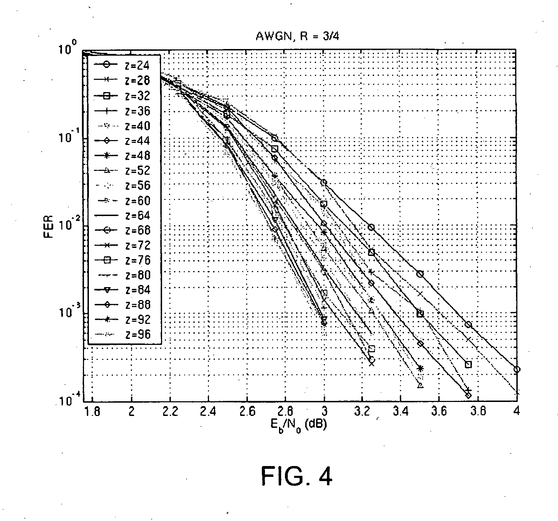

Performance of the updated Motorola design for 802.16e in AWGN channel is shown in Figure 2, 3, and 4 for rate {1/2, 2/3, 3/4}. QPSK modulation was used. The block sizes N range from 576 to 2304 for all three code rates. The expansion factor z ranges from 24 to 96, as shown in the figures. The block size and the expansion factor are related by $n$ = 24*z.

While the invention has been particularly shown and described with reference to a particular embodiment, it will be understood by those skilled in the art that various changes in form and details may be made therein without departing from the scope of the invention as defined by the following claims.

**Claims**

1. A method for operating a transmitter that generates parity-check bits $\mathbf{p}=(p_0, ..., p_{m-1})$ based on a current symbol set $\mathbf{s}=(s_0, ..., s_{k-1})$, the method comprising the steps of:

    receiving the current symbol set $\mathbf{s}=(s_0, ..., s_{k-1})$;
    using a matrix $\mathbf{H}$ to determine the parity-check bits; and
    transmitting the parity-check bits along with the current symbol set;
    wherein $\mathbf{H}$ is an expansion of a base matrix $\mathbf{H}_b$ via a model matrix $\mathbf{H}_{bm}$,
    wherein $\mathbf{H}_b$ comprises $m_b$ rows, a section $\mathbf{H}_{b1}$ and a section $\mathbf{H}_{b2}$, and $\mathbf{H}_{b2}$ comprises column $\mathbf{h}_b$ having weight $w_h>=3$ and $\mathbf{H'}_{b2}$ having a dual-diagonal structure with matrix elements at row $i$, column j equal to 1 for $i=j$, 1 for $i=j+1$, and 0 elsewhere;
    **characterised in that** 1's of $\mathbf{h}_b$ and $\mathbf{H}_{b1}$ are arranged such that $m_b/q$ groups of the rows of $\mathbf{H}_{bm}$ each group having $q$ rows can be formed so that within each group the rows of $\mathbf{H}_{bm}$ have at most a single non-negative entry within a column.

2. The method of claim 1 wherein the rows of model matrix $\mathbf{H}_{bm}$ can be permuted such that every two consecutive rows do not intersect.

3. The method of claim 1 wherein when expanding the base matrix $\mathbf{H}_b$ to parity-check matrix H, identical submatrices are used for each of the 1's in each column of $\mathbf{H'}_{b2}$, and the expansion uses paired submatrices for an even number of 1's in $\mathbf{h}_b$.

4. The method of claim 3 where the submatrices are zxz shifted identity matrices.

5. An apparatus comprising:

    storage means for storing a matrix $\mathbf{H}$; and
    digital logic receiving an information block $\mathbf{s}=(s_0, ..., s_{k-1})$, determining parity-check bits $\mathbf{p}=(p_0, ... , p_{m-1})$ based on the current symbol set $\mathbf{s} = (\text{so}, ..., s_{k-1})$ and the matrix $\mathbf{H}$, and transmitting the parity-check bits along with the current symbol set;
    wherein $\mathbf{H}$ is an expansion of a base matrix $\mathbf{H}_b$ via a model matrix $\mathbf{H}_{bm}$,
    wherein $\mathbf{H}_b$ comprises $m_b$ rows, a section $\mathbf{H}_{b1}$ and a section $\mathbf{H}_{b2}$, and $\mathbf{H}_{b2}$ comprises column $\mathbf{h}_b$ having weight $w_h>=3$ and $\mathbf{H'}_{b2}$ having a dual-diagonal structure with matrix elements at row $i$, column j equal to 1 for $i=j$, 1 for $i=j+1$, and 0 elsewhere;
    **characterised in that** 1's of $\mathbf{h}_b$ and $\mathbf{H}_{b1}$ are arranged such that $m_b/q$ groups of the rows of $\mathbf{H}_{bm}$ each group having $q$ rows can be formed so that within each group the rows of $\mathbf{H}_{bm}$ have at most a single non-negative entry within a column.

6. The apparatus of claim 5 wherein rows of model matrix $\mathbf{H}_{bm}$ can be permuted such that every two consecutive rows do not intersect.

7. The apparatus of claim 5 wherein when expanding the base matrix $\mathbf{H}_b$ to parity-check matrix H, identical submatrices are used for each of the 1's in each column of $\mathbf{H'}_{b2}$, and the expansion uses paired submatrices for an even number of 1's in $\mathbf{h}_b$.

8. The apparatus of claim 7 where the submatrices are $z \times z$ shifted identity matrices.

9. A method for operating a receiver that estimates an information block $\mathbf{s}=(s_0, ..., s_{k-1})$, the method comprising the steps of:

    receiving a signal vector;
    estimating the information block $\mathbf{s}=(s_0, ..., s_{k-1})$ based on the received signal vector and a parity-check matrix $\mathbf{H}$;
    wherein $\mathbf{H}$ is an expansion of a base matrix $\mathbf{H}_b$ via a model matrix $\mathbf{H}_{bm}$,
    wherein $\mathbf{H}_b$ comprises $m_b$ rows, a section $\mathbf{H}_{b1}$ and a section $\mathbf{H}_{b2}$, and $\mathbf{H}_{b2}$ comprises column $\mathbf{h}_b$ having weight $w_h>=3$ and $\mathbf{H'}_{b2}$ having a dual-diagonal structure with matrix elements at row $i$, column $j$ equal to 1 for $i=j$, 1 for $i=j+1$, and 0 elsewhere;
    **characterised in that** 1's of $\mathbf{h}_b$ and $\mathbf{H}_{b1}$ are arranged such that $m_b/q$ groups of the rows of $\mathbf{H}_{bm}$ each group having $q$ rows can be formed so that within each group the rows of $\mathbf{H}_{bm}$ have at most a single non-negative entry within a column.

10. The method of claim 9 wherein rows of the model matrix $\mathbf{H}_{bm}$ can be permuted such that every two consecutive rows do not intersect.

11. The method of claim 9 wherein when expanding the base matrix $\mathbf{H}_b$ to parity-check matrix H, identical submatrices are used for each of the 1's in each column of $\mathbf{H}'_{b2}$, and the expansion uses paired submatrices for an even number of 1's in $\mathbf{h}_b$.

12. An apparatus comprising:

   storage means for storing a matrix $\mathbf{H}$; and
   digital logic receiving a signal vector and estimating the information block s=(so, ..., $s_{k-1}$) based on the received signal vector and the matrix $\mathbf{H}$;
   wherein $\mathbf{H}$ is an expansion of a base matrix $\mathbf{H}_b$ via a model matrix $\mathbf{H}_{bm}$,
   wherein $\mathbf{H}_b$ comprises $m_b$ rows, a section $\mathbf{H}_{b1}$ and a section $\mathbf{H}_{b2}$, and $\mathbf{H}_{b2}$ comprises column $\mathbf{h}_b$ having weight $w_h>=3$ and $\mathbf{H}'_{b2}$ having a dual-diagonal structure with matrix elements at row $i$, column $j$ equal to 1 for $i=j$, 1 for $i=j+1$, and 0 elsewhere;
   **characterised in that** 1's of $\mathbf{h}_b$ and $\mathbf{H}_{b1}$ are arranged such that $m_b/q$ groups of the rows of $\mathbf{H}_{bm}$ each group having $q$ rows can be formed so that within each group the rows of $\mathbf{H}_{bm}$ have at most a single non-negative entry within a column.

13. The apparatus of claim 12 wherein the rows of model matrix $\mathbf{H}_{bm}$ can be permuted such that every two consecutive rows do not intersect.

**Patentansprüche**

1. Verfahren zum Bedienen eines Senders, der Paritätsprüfbits p=($p_{0, ..., }$ $p_{m-1}$) basierend auf einer aktuellen Symbolmenge s=($s_{0, ..., }$ $s_{k-1}$) erzeugt, wobei das Verfahren die Schritte umfasst:

   Empfangen der aktuellen Symbolmenge s=($s_{0, ..., }$ $s_{k-1}$);
   Benutzen einer Matrix H zum Bestimmen der Paritätsprüfbits; und
   Senden der Paritätsprüfbits gemeinsam mit der aktuellen Symbolmenge;
   wobei H eine Erweiterung einer Grundmatrix $H_b$ durch eine Modellmatrix $H_{bm}$ ist,
   wobei $H_b$ $m_b$ Zeilen, einen Abschnitt $H_{b1}$ und einen Abschnitt $H_{b2}$ umfasst und wobei $H_{b2}$ eine Spalte $h_b$ umfasst, die ein Gewicht $w_h >= 3$ hat, und wobei $H'_{b2}$ einen Doppeldiagonalaufbau mit Matrixelementen in Zeile i, Spalte j gleich 1 für i=j, 1 für i=j+1 und ansonsten 0 hat;
   **dadurch gekennzeichnet, dass** die 1'en aus $h_b$ und $H_{b1}$ derart angeordnet werden, dass $m_b/q$ Gruppen der Zeilen von $H_{bm}$, wobei jede Gruppe q Zeilen hat, derart gebildet werden können, dass innerhalb jeder Gruppe die Zeilen von $H_{bm}$ höchstens einen einzelnen nicht-negativen Eintrag innerhalb einer Spalte haben.

2. Verfahren nach Anspruch 1, wobei die Zeilen der Modellmatrix $H_{bm}$ so permutiert werden können, dass sich alle zwei aufeinander folgenden Zeilen nicht schneiden.

3. Verfahren nach Anspruch 1, wobei, wenn die Grundmatrix $H_b$ zur Paritätsprüfmatrix H erweitert wird, identische Submatrizen für jede der 1'en in jeder Spalte von $H'_{b2}$ benutzt werden und die Erweiterung gepaarte Submatrizen für eine gerade Anzahl von 1'en in $h_b$ benutzt.

4. Verfahren nach Anspruch 3, wobei die Submatrizen zxz verschobene Einheitsmatrizen sind.

5. Vorrichtung umfassend:

   ein Speichermedium zum Speichern einer Matrix H; und
   eine digitale Logik, die einen Informationsblock s=($s_{0, ..., }$ $s_{k-1}$) empfängt, Paritätprüfbits p=($p_{0, ..., }$ $p_{m-1}$) basierend auf der aktuellen Symbolmenge s=($s_{0, ..., }$ $s_{k-1}$) und der Matrix H bestimmt, und die Paritätprüfbits zusammen mit der aktuellen Symbolmenge sendet;

wobei H eine Erweiterung einer Grundmatrix $H_b$ durch eine Modellmatrix $H_{bm}$ ist,
wobei $H_b$ $m_b$ Zeilen, einen Abschnitt $H_{b1}$ und einen Abschnitt $H_{b2}$ umfasst und wobei $H_{b2}$ eine Spalte $h_b$ umfasst, die ein Gewicht $w_h >= 3$ hat, und wobei $H'_{b2}$ einen Doppeldiagonalaufbau mit Matrixelementen in Zeile i, Spalte j gleich 1 für i=j, 1 für i=j+1 und ansonsten 0 hat;
**dadurch gekennzeichnet, dass** die 1'en von $h_b$ und $H_{b1}$ derart angeordnet sind, dass $m_b/q$ Gruppen der Zeilen von $H_{bm}$, wobei jede Gruppe q Zeilen hat, derart gebildet werden können, dass innerhalb jeder Gruppe die Zeilen von $H_{bm}$ höchstens einen einzelnen nicht-negativen Eintrag innerhalb einer Spalte haben.

**6.** Vorrichtung nach Anspruch 5, wobei die Zeilen der Modellmatrix $H_{bm}$ so permutiert sein können, dass sich alle zwei aufeinander folgenden Zeilen nicht kreuzen.

**7.** Vorrichtung nach Anspruch 5, wobei, wenn die Grundmatrix $H_b$ zur Paritätsprüfmatrix H erweitert wird, identische Submatrizen für jede der 1'en in jeder Spalte von $H'_{b2}$ benutzt werden und die Erweiterung gepaarte Submatrizen für eine gerade Anzahl von 1'en in $h_b$ benutzt.

**8.** Vorrichtung nach Anspruch 7, wobei die Submatrizen zxz verschobene Einheitsmatrizen sind.

**9.** Verfahren zum Bedienen eines Empfängers, der einen Informationsblock $s=(s_{0, ...,} s_{k-1})$ berechnet, wobei das Verfahren die Schritte umfasst:

Empfangen eines Signalvektors;
Berechnen des Informationsblocks $s=(s_{0,.....,} s_{k-1})$ basierend auf dem empfangenem Signalvektor und einer Paritätsprüfmatrix H;
wobei H eine Erweiterung der Grundmatrix $H_b$ durch eine Modellmatrix $H_{bm}$ ist,
wobei $H_b$ $m_b$ Zeilen, einen Abschnitt $H_{b1}$ und einen Abschnitt $H_{b2}$ umfasst und wobei $H_{b2}$ eine Spalte $h_b$ umfasst, die ein Gewicht $w_h >=3$ hat, und wobei $H'_{b2}$ einen Doppeldiagonalaufbau mit Matrixelementen in Zeile i, Spalte j gleich 1 für i=j, 1 für i=j+1, und ansonsten 0 hat;
**dadurch gekennzeichnet, dass** die 1'en von $h_b$ und $H_{b1}$ derart angeordnet werden, dass $m_b/q$ Gruppen der Zeilen von $H_{bm}$, wobei jede Gruppe q Zeilen hat, derart gebildet werden können, dass innerhalb jeder Gruppe die Zeilen von $H_{bm}$ höchstens einen einzelnen nicht-negativen Eintrag innerhalb einer Spalte haben.

**10.** Verfahren nach Anspruch 9, wobei die Zeilen der Modellmatrix $H_{bm}$ so permutiert werden können, dass sich alle zwei aufeinander folgenden Zeilen nicht schneiden.

**11.** Verfahren nach Anspruch 9, wobei identische Submatrizen für jede der 1'en in jeder Spalte von $H'_{b2}$ benutzt werden, wenn die Grundmatrix $H_b$ zur Paritätsprüfmatrix H erweitert wird und die Erweiterung gepaarte Submatrizen für eine gerade Anzahl von 1'en in $h_b$ benutzt.

**12.** Vorrichtung umfassend:

ein Speichermedium zum Speichern einer Matrix H; und
eine digitale Logik, die eine Signalvektor empfängt und den Informationsblock $s= (s_{0, ...,} s_{k-1})$ basierend auf dem empfangenen Signalvektor und der Matrix H berechnet;
wobei H eine Erweiterung der Grundmatrix $H_b$ durch eine Modellmatrix $H_{bm}$ ist,
wobei $H_b$ $m_b$ Zeilen, einen Abschnitt $H_{b1}$ und einen Abschnitt $H_{b2}$ umfasst und wobei $H_{b2}$ eine Spalte $h_b$ umfasst, die ein Gewicht $w_h >=3$ hat, und wobei $H_{b2}$ einen Doppeldiagonalaufbau mit Matrixelementen in Zeile i, Spalte j gleich 1 für i=j, 1 für i=j+1 und ansonsten 0 hat;
**dadurch gekennzeichnet, dass** die 1'en von $h_b$ und $H_{b1}$ derart angeordnet sind, dass $m_b/q$ Gruppen der Zeilen von $H_{bm}$, wobei jede Gruppe q Zeilen hat, derart gebildet werden können, dass innerhalb jeder Gruppe die Zeilen von $H_{bm}$ höchstens einen einzelnen nicht-negativen Eintrag innerhalb einer Spalte haben.

**13.** Vorrichtung nach Anspruch 12, wobei die Zeilen der Modellmatrix $H_{bm}$ so permutiert sein können, dass sich alle zwei aufeinander folgenden Zeilen nicht schneiden.

**Revendications**

**1.** Procédé pour employer un transmetteur qui génère des bits de vérification parité $\mathbf{p}=(p_0, ..., p_{m-1})$ à base d'un ensemble de symboles courant $\mathbf{s}=(s_0, ..., s_{k-1})$, le procédé comprenant les étapes de :

recevoir l'ensemble de symboles courant $\mathbf{s}=(s_0, ..., s_{k-1})$ ;
utiliser une matrice $\mathbf{H}$ pour déterminer les bits de vérification parité ; et
transmettre les bits de vérification parité ensemble avec l'ensemble de symboles courant ;
dans lequel $\mathbf{H}$ est une expansion de la matrice de base $\mathbf{H}_b$ via une matrice modèle $\mathbf{H}_{bm}$, dans lequel $\mathbf{H}_b$ comprend $m_b$ lignes, une section $\mathbf{H}_{b1}$ et une section $\mathbf{H}_{b2}$, et $\mathbf{H}_{b2}$ comprend une colonne $\mathbf{h}_b$ ayant un poids $w_h \geq 3$ et $\mathbf{H'}_{b2}$ ayant une structure duale-diagonale avec des éléments de matrice à la ligne i, colonne $j$ égal à 1 pour $i=j$, 1 pour $i=j+1$, et 0 ailleurs ;
**caractérisé en ce que** les 1's de $\mathbf{h}_b$ et $\mathbf{H}_{b1}$ sont arrangés tel que $m_b/q$ groupes de lignes de $\mathbf{H}_{bm}$ chaque groupe ayant $q$ lignes peuvent être formés tel que dans chaque groupe les lignes de $\mathbf{H}_{bm}$ ont au moins une seule entrée non négative dans une colonne.

2. Procédé selon la revendication 1, dans lequel les lignes de la matrice modèle $\mathbf{H}_{bm}$ peuvent être permutées tel que toutes les deux lignes consécutives ne se croisent pas.

3. Procédé selon la revendication 1, dans lequel des sous-matrices identiques sont utilisés pour chacun des 1's dans chaque colonne de $\mathbf{H'}_{b2}$, et l'expansion utilise des sous-matrices géminées pour un nombre pair de 1's en $\mathbf{h}_b$ lors de l'expansion de la matrice de base $\mathbf{H}_b$ afin de vérifier parité de la matrice $\mathbf{H}$.

4. Procédé selon la revendication 3 dans lequel les sous-matrices sont des matrices identité zxz décalés.

5. Un dispositif comprenant :

des moyens de stockage pour stocker une matrice $\mathbf{H}$ ; et
logique numérique recevant un bloc information $\mathbf{s}=(s_0, ..., s_{k-1})$, déterminant des bits de vérification parité $\mathbf{p}=(p_0, ... , p_{m-1})$ à base de l'ensemble de symboles courant $\mathbf{s}=(s_0, ..., s_{k-1})$ et la matrice $\mathbf{H}$, et transmettre les bits de vérification parité ensemble avec l'ensemble de symboles courant ;
dans lequel H est une expansion d'une matrice de base $\mathbf{H}_b$ via une matrice modèle $\mathbf{H}_{bm}$, dans lequel $\mathbf{H}_b$ comprend $m_b$ lignes, une section $\mathbf{H}_{b1}$ et une section $\mathbf{H}_{b2}$, et $\mathbf{H}_{b2}$ comprend une colonne $\mathbf{h}_b$ ayant un poids $w_h \geq 3$ et $\mathbf{H'}_{b2}$ ayant une structure duale-diagonale avec des éléments de matrice à la ligne $i$, colonne $j$ égal à 1 pour $i=j$, 1 pour $i=j+1$, et 0 ailleurs ;
**caractérisé en ce que** des 1's de $\mathbf{h}_b$ et $\mathbf{H}_{b1}$ sont arrangés tel que $m_b/q$ groupes des lignes de $\mathbf{H}_{bm}$ chaque groupe ayant q lignes peuvent être formés tel que dans chaque groupe les lignes de $\mathbf{H}_{bm}$ ont au moins une seule entrée non négative dans une colonne.

6. Dispositif selon la revendication 5 dans lequel des lignes de la matrice modèle $\mathbf{H}_{bm}$ peuvent être permutées tel que toutes les deux lignes consécutives ne se croisent pas.

7. Dispositif selon la revendication 5 dans lequel des sous-matrices identiques sont utilisés pour chacun des 1's dans chaque colonne de $\mathbf{H'}_{b2}$, et l'expansion utilise des sous-matrices géminées pour un nombre pair de 1's en $\mathbf{h}_b$ lors de l'expansion de la matrice de base $\mathbf{H}_b$ afin de vérifier parité de la matrice $\mathbf{H}$.

8. Dispositif selon la revendication 7 dans lequel les sous-matrices sont des matrices identité zxz décalés.

9. Procédé pour employer un récepteur qui estime un bloc d'information $\mathbf{s}=(s_0,...,s_{k-1})$, le procédé comprenant les étapes de :

recevoir un vecteur signal ;
estimer le bloc information $\mathbf{s}=(s_0, ..., s_{k-1})$ à base du vecteur signal reçu et une matrice de vérification parité $\mathbf{H}$ ;
dans lequel $\mathbf{H}$ est une expansion de la matrice de base $\mathbf{H}_b$ via une matrice modèle $\mathbf{H}_{bm}$, dans lequel $\mathbf{H}_b$ comprend $m_b$ lignes, une section $\mathbf{H}_{b1}$ et une section $\mathbf{H}_{b2}$, et $\mathbf{H}_{b2}$ comprend une colonne $\mathbf{h}_b$ ayant un poids $w_h \geq 3$ et $\mathbf{H'}_{b2}$ ayant une structure duale-diagonale avec des éléments de matrice à la ligne $i$, colonne $j$ égal à 1 pour $i=j$, 1 pour $i=j+1$, et 0 ailleurs ;
**caractérisé en ce que** les 1's de $\mathbf{h}_b$ et $\mathbf{H}_{b1}$ sont arrangés tel que $m_b/q$ groupes des lignes de $\mathbf{H}_{bm}$ chaque groupe ayant $q$ lignes peuvent être formés tel que dans chaque groupe les lignes de $\mathbf{H}_{bm}$ ont au moins une seule entrée non négative dans une colonne.

**10.** Procédé selon la revendication 9, dans lequel des lignes de la matrice modèle $H_{bm}$ peuvent être permutées tel que toutes les deux lignes consécutives ne se croisent pas.

**11.** Procédé selon la revendication 9, dans lequel des sous-matrices identiques sont utilisés pour chacun des 1's dans chaque colonne de $H'_{b2}$, et l'expansion utilise des sous-matrices géminées pour un nombre pair de 1's en $h_b$ lors de l'expansion de la matrice de base $H_b$ afin de vérifier parité de la matrice $H$.

**12.** Dispositif comprenant :

des moyens de stockage pour stocker une matrice $H$ ; et
de la logique numérique recevant un vecteur signal et estimant le bloc information $s=(s_0, \dots, s_{k-1})$ à base du vecteur signal reçu et de la matrice $H$ ;
dans lequel $H$ est une expansion de la matrice de base $H_b$ via une matrice modèle $H_{bm}$, dans lequel $H_b$ comprend $m_b$ lignes, une section $H_{b1}$ et une section $H_{b2}$, et $H_{b2}$ comprend une colonne $h_b$ ayant un poids $w_h >= 3$ et $H'_{b2}$ ayant une structure duale-diagonale avec des éléments de matrice à la ligne $i$, colonne $j$ égal à 1 pour $i=j$, 1 pour $i=j+1$, et 0 ailleurs ;
**caractérisé en ce que** les 1's de $h_b$ et $H_{b1}$ sont arrangés tel que $m_b/q$ groupes de lignes de $H_{bm}$ chaque groupe ayant q lignes peuvent être formés tel que dans chaque groupe les lignes de $H_{bm}$ ont au moins une seule entrée non négative dans une colonne.

**13.** Dispositif selon la revendication 12 dans lequel les lignes de la matrice modèle $H_{bm}$ peuvent être permutées tel que toutes les deux lignes consécutives ne se croisent pas.

FIG. 1

FIG. 3

FIG. 2

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10839995 B

**Non-patent literature cited in the description**

- **ROBERT XU ; LIUQING YUAN ; YOUGANG ZHANG ; LI ZENG.** *High Girth LDPC coding for OFD-MA PHY,* 03 November 2004, http://www.ieee802.org/16/tge/contrib/C80216e-04_423.pdf